# EUROPEAN PATENT APPLICATION

(11) **EP 0 935 289 A2**
(43) Date of publication of application: **11.08.1999**
(21) Application number: 99101441.6
(22) Date of filing: 27.01.1999
(51) Int. Cl.: H01L 23/544

(54) **Substrate marking process**

(30) Priority: 06.02.1998 SG 9802595
(71) Applicant: Questech Solutions Pte. Ltd., Singapore 739256 (SG)
(72) Inventor: Lian, Tiang Siong, Singapore 464094 (SG)
(74) Representative: RACKETTE Partnerschaft Patentanwälte

(57) **Abstract**

The present substrate marking process can produce markings of small dimensions without damaging the underlying substrate. A substrate is first preconditioned to remove any moisture from its surface to be marked. A coating mixture containing plate resin and thinner is coated onto the substrate surface. The substrate is baked in an oven to harden the coating mixture. Once hardened, a laser is used to etch the markings on the surface of the hardened mixture.

## Description

### FIELD OF THE INVENTION

This invention relates generally to the field of semiconductor processing, and particularly to a method of marking a surface of a substrate where the marking process does not degrade the substrate's functional properties.

### BACKGROUND OF THE INVENTION

In the field of semidconductors, there is a need to place letters or codes on semiconductor packages for identification purposes (known as "marking"). Currently, the marking of molded packages is done using an ink-pad or laser and the marking is done on the molded surface. As the semiconductor industry is moving towards flip-chip-attached packaging, changes in the designs have been made which affect the marking process. For one, the flip-chip-attached packaging does not need molding, and so it may not be possible to have a molded surface to make the marking. Moreover, the packaging dimensions are constantly becoming smaller, and hence, the markings must also become smaller.

In addition, the markings are being done during different stages of semiconductor fabrication process. For instance, in the case of flip-chips, the chips are marked for device type and logo soon after they are assembled. After testing, the flip chips are further marked to indicate performance ratings such as speed.

For the flip chips, it is possible, and moreover, efficient to pre-mark the logo and device type at the wafer level before assembly. However, currently, this process is not being used because the current marking methods are not adapted for such a use. For the ink-pad method, it is difficult to achieve small dimensions, and the ink does not adhere well to the wafer substrate. For the current laser method, the laser beam can damage the semiconductor substrate which may cause performance degradation in the end product.

Because speed and yield are important attributes of wafer processing, a wafer marking method is of great importance. Ideally, the marking process should be easy and reliable, and the resulting markings should be clean and easy to read. Moreover, the process must not affect the relevant properties of the wafer material so as to adversely affect the performance of the eventual semiconductor device which will carry the dies produced from the marked wafers. Currently, however, there is no effective means for marking the wafers. Therefore, there is a need in the industry for a method of marking semiconductor wafers which is easy, relatively fast, reliable, and which produces good results, and which does not damage the underlying substrate.

### OBJECT OF THE INVENTION

Therefore, it is an object of the present invention to provide a method of marking semiconductor substrate which is easy, relatively fast, reliable, and which does not damage the semiconductor substrate.

### SUMMARY OF THE INVENTION

The preferred method of marking first involves pre-conditioning of the water. During pre-conditioning, the wafer is placed in an oven at around 80 °C for about 5 minutes. The purpose of the pre-conditioning process is to prepare the wafer for the next step which is to coat the backside with a resist polymer. By warming the wafer, adhesion is improved between the wafer surface and the polymer coating by removing any moisture on the wafer surface.

After the pre-conditioning, the wafer is spin coated with a polymer-based coating mixture. Although a number of compounds can be used as the base material for the coating mixture, the preferred compound is a plating resist such as one sold by Peters under the name SD2153AL/BS.

The coating mixture is prepared by mixing the resist with a thinner. In one experiment, 15 grams of the resist was mixed with 3 ml of thinner at 23 °C with good results. A good coating mixture should have good thixotropic properties and flow characteristics such that it can coat the wafer surface unformly and smoothly. Once hardened, the coating should adhere well to the wafer backside surface. It is also preferable that the coating have high pencil hardness, little impurity ion, and is resistant to scratches and corrosion. Since the wafer will undergo different chemical processings, the coating should be chemically resistant to various chemical agents used in wafer processing. The coating should also be able to withstand high temperatures, i.e., above 230 °C without degrading.

When coating the backside of the wafer surface, it is important that the coating mixture does not flow over to the front side. While the coating mixture can be applied to the wafer surface using various techniques, the spin coating technique yielded the best results. In the preferred embodiment, the wafer was initially rotated at 1000 rpm for 30 seconds followed by 3500 rpm for 50 seconds.

Once the wafer backside is fully coated, the wafer is baked in an oven at 100 °C for about 30 to 40 minutes to harden the coating. Once hardened, the coating typically has a thickness of about 3.5 µm. Now the wafer is ready to be marked.

The marking is done using a laser. Preferably, the laser should facilitate good resolution, that is, the beam should be able to make fine details. Also, the beam-spot-size-to-resist-burn-in-diameter ratio should be comparable, and the dose energy of the beam should be consistent across the entire wafer surface. In the present invention, CO₂ laser with λ=10.6 µm was used with good results. Experiments have shown that for best contrast of the markings, a power range of 5 to 10 W and marking speed of 100 to 200 cm/sec. should preferably be used. The marking process creates some debris on the surface of the wafer which can easily be removed using a cleaning agent.

### DETAILED DESCRIPTION OF THE INVENTION

The preferred process of the present substrate marking invention shall be described. Although here, the method shall be described in relation to a semiconductor wafer substrate, it shall be appreciated that the substrate need not necessarily be in a wafer form. Furthermore, although many of the parameters for the following process shall be described with specificity in order to fully describe the preferred embodiment of the present invention, it shall be appreciated that a range of values are possible for the parameters. Therefore, the following should be treated as illustration only, and should not be construed as the only way to mark semiconductor substrates using the described method.

The preferred method of marking a backside of a wafer first involves pre-conditioning of the water. During pre-conditioning, the wafer is placed in an oven at around 80 °C for about 5 minutes. The purpose of the pre-conditioning process is to prepare the wafer for the nest step which is to coat the backside with a resist polymer. By warming the wafer, adhesion is improved between the wafer surface and the polymer coating by removing any moisture on the wafer surface. Although the pre-conditioning is highly desirable in order to produce the best marking result, it is possible to eliminate this step without completely rendering the present method ineffective.

After the pre-conditioning, the wafer is spin coated with a polymer-based coating mixture. Although a number of compounds can be used as the base material for the coating mixture, the preferred compound is a plating resist such as one sold by Peters under the name SD2153AL/BS. However, other similar compounds are also possible. While a number of compounds are possible, it is desirable to have a compound which has high solids content to ensure good edge coverage, good thermosetting properties to ensure heat resistance reliability, and which has opaque color for better contrast between the markings and the wafer surface,

The coating mixture is prepared by mixing the resist with a thinner. In one experiment, 15 grams of the resist was mixed with 3 ml of thinner at 23 °C with good results. A good coating mixture should have good thixotropic properties and flow characteristics such that it can coat the wafer surface unformly and smoothly. Once hardened, the coating should adhere well to the wafer backside surface. It is also preferable that the coating have high pencil hardness, little impurity ion, and is resistant to scratches and corrosion. Since the water will undergo different chemical processings, the coating should be chemically resistant to various chemical agents used in water processing. The coating should also be able to withstand high temperatures, i.e., above 230 °C without degrading.

When coating the backside of the wafer surface, it is important that the coating mixture does not flow over to the front side. While the coating mixture can be applied to the wafer surface using various techniques, the spin coating technique yielded the best results. In the preferred embodiment, the water was initially rotated at 1000 rpm for 30 seconds followed by 3500 rpm for 50 seconds.

Once the wafer backside is fully coated, the wafer is baked in an oven at 100 °C for about 30 to 40 minutes to harden the coating. Once hardened, the coating typically has a thickness of about 3.5 µm. Now the wafer is ready to be marked.

The marking is done using a laser. Preferably, the laser should facilitate good resolution, that is, the beam should be able to make fine details. Also, the beam-spot-size-to-resist-burn-in diameter ratio should be comparable, and the dose energy of the beam should be consistent across the entire wafer surface. In the present invention, CO₂ laser with λ=10.6 µm was used with good results. Experiments have shown that for best contrast of the markings, a power range of 5 to 10 W and marking speed of 100 to 200 cm/sec. should preferably be used. The marking process creates some debris on the surface of the wafer which can easily be removed using a cleaning agent.

The following table lists the complete laser specifications which were used in the present invention. However, it should be understood that the values listed in the table below are provided herein for illustration purposes only, and should not be construed to be the only set of values which are possible.

| SPECIFICATIONS | CO₂ |
|---|---|
| Laser Type | 25W CW sealed CO₂ laser |
| Operating Temperature Range | 25 + 5 °C |
| Electrical Requirement | 3 phase 50/60 Hz (220V) |
| Power | Max 25 Watt |
| Power Stability | ±5% |
| Max Laser Power Density | 200 W/cm² |
| Beam Diameter | 3.5 mm |
| Beam Divergence | 4 mR |
| Polarisation | Linear vertical 50-1 |
| Wavelength | 10.6 µm |
| Laser Lifetime | Up to 20,000 firing hours |
| Spot Size | 230 µm |
| Marking Speed | 150 characters/sec. (1 mm characters) |
| Field Size | 100 × 100 mm |
| F-Theta Focal Length | 150 mm |
| Step Response Time | 1.5 msec |
| Thermal Drift | <20 µm/°C ambient |
| Long Term Drift (8 hrs.) | <±0.1 mm |
| Repeatability | <±-0.05 mm |

The present invention may be embodied in other specific forms without departing from the spirit or essential characteristics thereof. For instance, although the above process has been described for wafer surfaces, it is possible to use a similar method to mark other substrates such as PCB surfaces, though with PCBs, it is preferable to use a solder resist as the resist coating material. Similarly, other surfaces can also be marked where the advantages of the present marking method are desired. The presently disclosed embodiments are, therefore, to be considered in all respects as illustrative and not restrictive, the scope of the invention being indicated by the appended claims and all changes which come within the meaning and range of equivalency of the claims are, therefore, to be embraced therein.

## Claims

1. A method of marking a surface of semiconductor substrate comprising:
coating the substrate surface with a coating mixture;
hardening said coating mixture to yield a thin hardened layer of said coating mixture;
focusing a laser beam onto said hardened layer to create a marking, wherein sufficient visible contrast exists between said marking and said hardened layer.

2. The method as recited in Claim 1 further comprising a step of pre-conditioning said semiconductor substrate before coating the surface with a coating mixture.

3. The method as recited in Claim 2 wherein said pre-conditioning step includes placing said substrate in an oven at around 80 °C for about 5 minutes.

4. The method as recited in Claim 1 wherein said substrate is a wafer.

5. The method as recited in Claim 2 wherein said substrate is a wafer.

6. The method as recited in Claim 1 wherein said hardening step includes baking said substrate at around 100 °C for about 30 to 40 minutes.

7. The method as recited in Claim 2 wherein said hardening step includes baking said substrate at around 100 °C for about 30 to 40 minutes.

8. The method as recited in Claim 1 wherein said coating mixture contains plate resin.

9. The method as recited in Claim 1 wherein said coating mixture comprises plate resin and thinner.

10. The method as recited in Claim 9 wherein said mixture has a ratio of 5 grams of plate resin per 1 ml of thinner.

11. The method as recited in Claim 2 wherein said coating mixture contains plate resin.

12. The method as recited in Claim 1 wherein said coating mixture is spin coated.

13. The method as recited in Claim 2 wherein said coating mixture is spin coated.

14. The method as recited in Claim 4 wherein said coating mixture is spin coated.

15. The method as recited in Claim 5 wherein said coating mixture is spin coated.

16. The method as recited in Claim 1 wherein said laser beam is produced from a CO₂ laser with λ= 10.6 µm, said beam having a power in the range of 5 to 10 W.

17. The method as recited in Claim 16 wherein said marking is performed at a speed of 100 to 200 cm/s.

18. The method as recited in Claim 2 wherein said laser beam is produced from a CO₂ laser with λ=10.6 µm, said beam having a power in the range of 5 to 10 W.

19. The method as recited in Claim 18 wherein said marking is performed at a speed of 100 to 200 cm/s.

20. A method of marking a surface of PCB substrate comprising:
coating the PCB substrate surface with a coating mixture;
hardening said coating mixture to yield a thin hardened layer of said coating mixture;
focusing a laser beam onto said hardened layer to create a marking, wherein sufficient visible contrast exists between said marking and said hardened layer.

21. The method as recited in Claim 20 wherein said coating mixture contains solder resin.

22. The method as recited in Claim 21 wherein said coating mixture comprises solder resin and thinner.

23. The method as recited in Claim 20 further comprising a step of pre-conditioning said PCB substrate before coating the surface with the coating mixture.

24. The method as recited in Claim 23 wherein said hardening step includes baking said substrate at around 100 °C for about 30 to 40 minutes.
